# EUROPÄISCHE PATENTANMELDUNG

(11) **EP 3 309 578 A1**
(43) Veröffentlichungstag der Anmeldung: **18.04.2018**
(21) Anmeldenummer: 16193182.9
(22) Anmeldetag: 11.10.2016
(51) Int. Cl.: G01S 7/40, F41H 11/136, G01S 13/02, G01S 13/86, G01S 13/88, G01V 3/12, G01S 13/10

(54) **VERFAHREN ZUR ERMITTLUNG EINER RELATIVEN DIELEKTRIZITÄTZAHL UND DETEKTIONSVERFAHREN ZUM AUFFINDEN VON GEGENSTÄNDEN IM ERDREICH**

(71) Anmelder: Vallon GmbH, 72800 Eningen (DE)
(72) Erfinder: Fahlbusch, Jan, 38102 Braunschweig (DE); Merz, Armin, 72800 Eningen unter Achalm (DE)
(74) Vertreter: Klocke, Peter

(57) **Zusammenfassung**

Verfahren zur Ermittlung einer relativen Dielektrizitätszahl ε_{R} in einem nach Minen zu untersuchenden Erdreich unter Verwendung eines Suchgeräts mit mindestens einem Bodenradar mit mindestens einer Sendeantenne und einer Empfangsantenne sowie ein Detektionsverfahren zum Auffinden von Minen im Erdreich unter Verwendung eines Minensuchgeräts mit einem Metalldetektor und einem Bodenradar, wobei der Metalldetektor mindestens eine Suchspule mit einer Spulenebene, die beim Suchen parallel zum Boden zu bewegen ist, aufweist und der Bodenradar eine Antennenanordnung mit mindestens einer Sendeantenne und mindestens einer Empfangsantenne versehen ist. Mit dem erfindungsgemäßen Verfahren zur Ermittlung einer relativen Dielektrizitätszahl ε_{R} ist es somit für den Benutzer möglich schnell und in gewohnter Weise das Suchgerät im Hinblick auf die Bodenbeschaffenheit des zu untersuchenden Gebiets zu kalibrieren. Mit dem erfindungsgemäßen Detektionsverfahren, dem die ermittelte relative Dielektrizitätszahl zu Grunde liegt, werden dem Benutzer des Suchgeräts wesentliche für die Suche und die Detektion erforderlichen Daten zur Verfügung gestellt. Für den Benutzer wird damit die Handhabung des Suchgeräts wesentlich vereinfacht.

## Beschreibung

Die Erfindung betrifft ein Verfahren zur Ermittlung einer relativen Dielektrizitätszahl ε_{R} eines nach metallische oder nichtmetallische Gegenstände zu untersuchenden Erdreichs unter Verwendung eines Suchgeräts mit mindestens einem Bodenradar mit mindestens einer Sendeantenne und mindestens einer Empfangsantenne sowie ein Detektionsverfahren zum Auffinden von Minen im Erdreich unter Verwendung eines Minensuchgeräts mit einem Metalldetektor und einem Bodenradar, wobei der Metalldetektor mindestens eine Suchspule mit einer Spulenebene, die beim Suchen parallel zum Boden zu bewegen ist, aufweist und der Bodenradar eine Antennenanordnung mit mindestens einer Sendeantenne und einer Empfangsantenne versehen ist.

Bei der Suche von Gegenständen im Erdreich, insbesondere von Minen, ist es wünschenswert, neben der Lage unterhalb der Oberfläche wenigstens die ungefähre Tiefe des im Erdreich befindlichen Gegenstandes eingrenzen und abschätzen zu können. Das Problem besteht darin, dass zur Ermittlung der Tiefe, die üblicherweise mit den bekannten zur Suche verwendeten Geräten erfolgt, die Bodenbeschaffenheit bekannt sein muss. Bei den Suchgeräten, die dafür verwendet werden, handelt es sich im Wesentlichen um Geräte mit einem Bodenradar oder Kombinationsgeräte, die zusätzlich noch einen Metalldetektor enthalten. Mit den Kombinationsgeräten können sowohl metallische als auch nichtmetallische Gegenstände im Boden, was auch Minen ohne metallische Bestandteile beinhaltet, gefunden werden. Bei einem Bodenradar (GPR = Ground Penetrating Radar) handelt es sich um eine Vorrichtung, die eine zerstörungsfreie Charakterisierung des Untergrundes mit elektromagnetischen Wellen mit Frequenzen im Radarbereich erlaubt. Grundsätzlich gibt es zwei Prinzipien, bei denen entweder die Entfernung aus der Zeitdifferenz zwischen dem Senden eines Sendeimpulses mittels einer Sendeantenne und dem Eintreffen der reflektierten Signale an eine Empfangsantenne ermittelt wird oder die Differenzfrequenz bzw. Differenzphase zwischen Sende-und Empfangssignal ausgewertet wird. Generell wird eine möglichst große Bandbreite des Sendesignals angestrebt, um ein optimales Ergebnis hinsichtlich der Eindringtiefe in das Erdreich und der Auflösung der zu suchenden Strukturen (Minen, etc.) zu erreichen. Grundsätzlich kann es sich bei den Antennen um eine der bekannten Varianten planaren Dipolantennen handeln (linearer oder sich graduell aufweitender Dipol, Bowtie-Antenne, Dipol mit V-förmigen Schenkeln, Dipol mit kreis-, ellipsen- oder tropfenförmigen Schenkeln usw.), die aus einem nicht leitenden Material, beispielsweise Kunststoff, hergestellt ist und lediglich an ihren beiden Schenkeln metallisiert ist. Ein Bodenradar ist besonders dann geeignet, wenn es um Gegenstände geht, die so wenig Metall enthalten, dass es für einen Metalldetektor schwierig ist, dieses Metall zu finden. Da jedoch der dielektrische Kontrast zwischen beispielsweise einer Mine und dem Erdreich relativ groß sein kann, sind hierfür Geräte mit Bodenradar günstig.

Da der Bodenradar in bekannter Weise elektromagnetische Wellen mittels einer Sendeantenne in Form eines Dipols abstrahlt, hängt die Laufzeit des reflektierten Signals, das von einer Empfangsantenne empfangen wird, von der relativen Dielektrizitätszahl ε_{R} ab. Diese kann gemäß der Gleichung ε_{R} = (co / c)² mit der Übertragungsgeschwindigkeit co in Luft bzw. im Vakuum und der Geschwindigkeit c im Erdreich errechnet werden. Bei Kenntnis von ε_{R} kann somit über die Laufzeit eines in das Erdreich ausgesendeten Signals bis zum Empfang, die Tiefe eines Gegenstandes im Erdreich ermittelt werden. Die relative Dielektrizitätszahl ε_{R} wird neben der Beschaffenheit und Struktur einer Bodensubstanz (steinig, sandig, durchmischt, etc.) zusätzlich durch dessen Durchleuchtung bestimmt. Gegenüber einem trockenen Boden sind die Laufzeiten bei einem feuchten Boden und gleichermaßen auch die Dämpfung des durch den Boden laufenden Signals deutlich größer.

Das Vorgehen bei der Bestimmung der relativen Dielektrizitätszahl ε_{R} erfolgt derart, dass Referenzobjekte in zwei verschiedenen Tiefen in einem Bereich mit einer dem zu untersuchenden Gebiet entsprechenden Bodenzusammensetzung vergraben werden. Beide Referenzobjekte werden mittels eines Bodenradars erfasst und die Berechnung der relativen Dielektrizitätszahl ε_{R} erfolgt anhand der Differenz der gemessenen Laufzeit und der bekannten Abstände im Boden. Anschließend erfolgt ein manuelles Einstellen des Sensors hinsichtlich Messfrequenzbereich und Verstärkung so, dass beide Objekte gut detektiert werden können.

Der vorliegenden Erfindung liegt daher die Aufgabe zugrunde, eine bessere Möglichkeit zur Ermittlung der relativen Dielektrizitätszahl ε_{R}, sodass sie in einem anschließenden Detektionsverfahren zum Auffinden von insbesondere Minen im Erdreich direkt eingesetzt werden kann, um über die Tiefe eines Gegenstandes im Erdreich hinreichend genau abzuschätzen.

Diese Aufgabe wird erfindungsgemäß durch ein Verfahren gemäß dem Anspruch 1 sowie einem Detektionsverfahren gemäß dem nebengeordneten Anspruch 3 gelöst. Weitere vorteilhafte Ausgestaltungen sind den jeweiligen rückbezogenen Unteransprüchen zu entnehmen.

Gemäß der Erfindung erfolgt das Verfahren zur Ermittlung der relativen Dielektrizitätszahl ε_{R} derart, dass zuerst für einen repräsentativen Abschnitt des untersuchenden Erdreichs, beispielsweise am Rande des abzusuchenden Gebietes ausgewählt wird. Mithilfe eines Suchgeräts mit mindestens einem Bodenradar wird über die mindestens eine Sendeantenne ein Sendesignal abgesandt und über die mindestens eine Empfangsantenne das Empfangssignal empfangen und die Zeit zwischen Senden und Empfangen ermittelt. Diese Messungen werden durchgeführt zum einen, wenn das Suchgerät mit seiner für die Suche aktiven Seite a) vom Erdreich abgewandt ist und zum anderen b) auf dem Erdreich aufliegt. Die Messung a) wird durchgeführt, um für die spätere Ermittlung der relativen Dielektrizitätszahl ε_{R} einen reproduzierbaren Vergleichswert für die Ausbreitungsgeschwindigkeit des Signals in der Luft und im Fall b) einen Messwert für die Ausbreitungsgeschwindigkeit des Signals im Erdreich zu erhalten. Für die Messung a) wird somit eine Messung in der Luft durchgeführt, wobei es wichtig ist, dass sich keine Objekte in der unmittelbaren Umgebung zu den Antennen befinden, die die Vergleichsmessung stören könnten. Für die Messung b) kann ein Bereich am Rande eines zu untersuchenden Gebietes, der möglichst die gleiche Bodenbeschaffenheit wie das zu untersuchende Gebiet hat, als Referenzbereich verwendet werden, auf den das verwendete Suchgerät aufgelegt wird. Es kann erforderlich sein, den Bereich eventuell von dort befindlicher Flora zu befreien, da ein Pflanzenbewuchs ebenfalls Wasser enthält und die Messung zusätzlich beeinflusst.

Als nächstes wird die mittlere Signalgeschwindigkeit aus der Signallaufzeit über die Luft und dem direkten Signallaufweg in dem Suchgerät zwischen der Sendeantenne und der Empfangsantenne bei der Stellung a) bestimmt. Dabei verläuft der größte Teil des Signalanteils auf dem direkten Weg zwischen der Sendeantenne und der Empfangsantenne, wobei die übrigen Signalanteile über die Luft mit der Entfernung zum direkten Laufweg abnehmen. Sofern die Sendeantenne und die Empfangsantenne gemeinsam auf einer Leiterplatte angeordnet sind, findet eine Überkopplung auf dem direkten Weg zwischen den beiden Antennen über die Leiterplatte statt. Das empfangene Signal ist hinsichtlich seiner Signalform eine additive Vermischung aller Signalanteile, wodurch das empfangene Signal gegenüber dem Sendesignal hinsichtlich seiner Amplitude reduziert, verbreitert und zeitlich verschoben wird.

Entsprechend erfolgt auch eine Bestimmung der mittleren Signalgeschwindigkeit aus der Signallaufzeit zwischen der Sendeantenne und der Empfangsantenne über das Erdreich, über die Luft, und über den direkten Signallaufweg in dem Suchgerät bei der Stellung b), wobei auch hier das empfangene Signal hinsichtlich seiner Signalform eine Überlagerung aller Signalanteile ist, wodurch das empfangene Signal gegenüber dem Sendesignal hinsichtlich seiner Amplitude reduziert, verbreitert und zeitlich verschoben wird. Die Reduzierungen erfolgt durch die Signalabnahme mit der Entfernung und Dämpfung, die Verbreiterung durch unterschiedliche Geschwindigkeiten. Der wesentliche Anteil hier ist auch das auf den direkten Weg zwischen den beiden Antennen übergekoppelte Signal.

Die relative Dielektrizitätszahl ε_{R} wird dann aus dem Verhältnis der beiden mittleren Signalgeschwindigkeiten gemäß den Messungen a) und b) ermittelt. Dies ist deshalb möglich, weil durch den Vergleich der Ergebnisse aus der Messung a) mit den Ergebnissen der Messung aus b) lediglich die in der Messung b) ermittelten Unterschiede zu a) relevant sind. Bei diesem Verfahren wird mit einer Art von offenen Strukturen das Erdreich gemessen und die Rückwirkung des Erdreiches auf diese offene Struktur ermittelt. Diese Struktur ist in der Form offen, dass sie elektromagnetische Wellen mit einem elektrisches Feld erzeugt, das in den Boden eindringt und dessen Rückwirkungen gemessen werden. Die erwähnte Überkopplung zwischen den beiden Antennen besteht, wie erwähnt, aus verschiedenen Bestandteilen, die sehr eng an der Leiterplatte laufen und/oder die auch eine gewisse räumliche Ausdehnung in den Boden bzw. Luft hinein haben. Durch die beiden Messungen a) und b) ändern sich relativ zueinander die Bestandteile dieser Überkopplung. Es ist möglich, dass sich die Überkopplung auch verzögert. Grundsätzlich findet die Übertragung im sogenannten Nahfeld der Antenne statt. Unter Nahfeld wird ein Entfernungsbereich verstanden, der vergleichbar zu der Wellenlänge des Signals ist. Im Nahfeld kann die Betrachtung nur mittels sich ausbreiten der Potenzialfelder erfolgen; im Fernfeld reicht eine strahlungstheoretische Erklärung. Bei der Auswertung wird ein Signalanteil, der sowieso immer vorhanden ist, nämlich das durch direkte Überkopplung der Antennen gemessene Signal, zu Nutze gemacht. Dies kann eine Kopplung durch das Nahfeld der Antenne oder auch eine Oberflächenwelle, die in der Leiterplattenstruktur entlang läuft sein. Auf jeden Fall sind Anteile, die sehr konzentriert zwischen den beiden Antennen verlaufen und sich auch etwas in den Raum im Erdreich ausdehnen, mit üblichen Methoden der Signalverarbeitung, wie z.B. Kurvenanpassung mittels Gaußfunktion, setzen von Filtern oder Fenstern, auswertbar. Dies kann jedoch nicht genau getrennt werden. Es wurde erkannt, dass sich diese Überkopplung gegenüber einer Messung in der Luft reproduzierbar ändert, wenn sich die Bodeneigenschaften ändern, nämlich, wie vorstehend erwähnt, durch Änderung der zeitlichen Lage des Maximums, der Amplitude des Maximums und der Breite des Verlaufs.

Wie vorstehend ausgeführt, können sich die Antennen auf einem Träger, üblicherweise einer Leiterplatte, befinden. Da die Antennen in erster Linie elektromagnetische Wellen in den Boden senden sollen, sind sie mit ihrer Wirkungsfläche entsprechend ausgestaltet. Kommen an der Empfangsantenne Signalanteile an, die über die Luft auf der Wirkungsfläche sich entgegengesetzt (im Beispiel einer Leiterplatte über die Luft auf der dem Erdreich abgewandten Seite der Leiterplatte) ausgebreitet haben, so sind diese Anteile bei beiden Messungen a) und b) vorhanden. Gemäß einer besonders bevorzugten Ausgestaltung der Erfindung werden mindestens die aus der Atmosphäre auf den Bodenradar auftreffenden sowie die von dem Bodenradar in einer dem Erdreich entgegengesetzten Richtung ausgesandten elektromagnetischen Wellen mittels Absorberelementen abgeschirmt und die mittlere Signalgeschwindigkeit aus der Signallaufzeit zwischen der Sendeantenne und der Empfangsantenne über das Erdreich und dem direkten Signallaufweg in dem Suchgerät bei der Stellung b) bestimmt. Eine derartige Auswertung ist präziser, da sich über die Luft ausgebreitete Signalanteile bei der Messung a) im Wesentlichen zur Hälfte und bei der Messung b) im Wesentlichen vollständig unterdrückt werden. Die Ermittlung der Dielektrizitätszahl erfolgt mittels eines in dem Suchgerät integrierten Steuer- und Recheneinheit. Die Verwendung von Absorberelementen bei einem Bodenradar ist als solches eine gängige Maßnahme, wobei in bekannter Weise Hohlräume in den Absorberelementen geschaffen werden, um die abgestrahlten Wellen zu dämpfen. Diese Hohlräume werden an ihren Außenflächen durch ein, elektromagnetische Wellen absorbierendes (z.B. Schaumabsorber oder Gummiabsorber oder Absorberlack) und/oder reflektierendes Material (z.B. Metall) begrenzt. Damit werden von der mindestens einen Empfangsantenne auch keine Signale empfangen, die aus der Atmosphäre auf den Bodenradar auftreffen.

Mittels des vorstehenden Verfahrens kann somit die relative Dielektrizitätszahl für das Erdreich des zu untersuchenden Gebiets bestimmt werden. Sollte der Benutzer eine Änderung des Erdreichs während des Suchvorgangs feststellen, ist für das Gebiet mit dem veränderten Erdreich eine neue Ermittlung der geänderten Dielektrizitätszahl entsprechend dem beschriebenen Verfahren notwendig. Es kann somit auf einfache und schnelle Art und Weise die relative Dielektrizitätszahl für das zu untersuchende Gebiet bestimmt und auch auf Veränderungen im Erdreich eingegangen werden.

Mit der ermittelten relativen Dielektrizitätszahl für das zu untersuchende Gebiet kann die Detektion gemäß dem erfindungsgemäßen Detektionsverfahren durchgeführt werden. Dies erfolgt derart, dass unter Verwendung eines Minensuchgeräts mit einem Metalldetektor und einem Bodenradar, wobei der Metalldetektor mindestens eine Suchspule mit einer Spulenebene, die beim Suchen parallel zum Boden zu bewegen ist, aufweist und der Bodenradar eine Antennenanordnung mit mindestens einer Sendeantenne und einer Empfangsantenne versehen ist, zuerst für einen für das untersuchenden Erdreich repräsentativer Abschnitt des Erdreiches Messungen zur Ermittlung einer relativen Dielektrizitätszahl ε_{R} wie vorstehend beschrieben durchgeführt werden. Nachdem die relative Dielektrizitätszahl ermittelt ist, kann daraus der Messfrequenzbereich unter Berücksichtigung der frequenzabhängigen Dämpfung zugeordnet und die maximale frequenzabhängige und bodenabhängige Messtiefe ermittelt und vorzugsweise mittels einer entsprechenden Anzeigeeinrichtung angezeigt werden. Wie bereits ausgeführt, erhöht sich mit steigender relativer Dielektrizitätszahl auch frequenzabhängig die Dämpfung der in den Boden gesandten elektromagnetischen Wellen. Insofern ist es erforderlich, dem Benutzer optisch anzuzeigen, bei welcher Grenzfrequenz und bei welcher Verstärkung er welche Tiefen maximal detektieren kann. Anschließend werden oberhalb des zu untersuchenden Erdreiches entlang eines zu untersuchenden Weges Messungen zum Auffinden von im Erdreich befindlichen Minen durchgeführt. Dabei wird durch gleichzeitiges Aussenden von Signalen von der Suchspule und der mindestens einen Sendeantenne und Empfangen der von der Suchspule ausgesandten Impulse und der von der mindestens einen Sendeantenne ausgesandten mittels der mindestens einen Empfangsantenne empfangenen Signale ein Bodenprofil in üblicher Weise mit einer in dem Suchgerät befindlichen Steuer-und Rechnereinheit erstellt. Aus dem Bodenprofil wird die Größe und die Tiefe eines im Boden befindlichen Objektes ermittelt und ein optisches und/oder akustisches Signal bei der Erkennung eines im Boden detektierten Objektes ausgegeben. Die bodennahe Bewegung des Suchgeräts entspricht der üblichen Minensuche, bei dem das Suchgerät möglichst nahe am Boden, ohne diesen zu berühren, über das Erdreich geführt wird. Die bei der Messung über den Boden empfangenen Signale werden mit den üblichen und bekannten Verfahren der Signalverarbeitung und Signalauswertung bearbeitet, indem aus den einzelnen zeitabhängigen über den Detektionsweg empfangenen Signalen ein (farbliches) Tiefenwertprofil in Abhängigkeit vom Detektionsweg Werteprofil erstellt wird, das in bekannter Art und Weise bei dem Vorhandensein von in dem Erdreich befindlichen räumlich begrenzten (nicht ebenen) Objekten hyperbolische Verläufe aufweist, sodass daraus die Tiefe und die Größe des Objekts ermittelt werden kann. Der Scheitelpunkt der jeweiligen Hyperbel gibt die Tiefe und die Aufweitung der Hyperbel die ungefähre Form und Größe des Objekts an. Vorzugsweise kann daraus zum einen ein akustisches Signal für den Hinweis auf das Vorhandensein eines Objekts an einer ganz bestimmten Stelle und zum anderen eine grafische Darstellung auf einer Anzeigeeinrichtung in Form eines Displays ausgegeben werden.

Zweckmäßigerweise wird für den Bodenradar eine Sendefrequenz zwischen 400 MHz und 3 GHz verwendet.

Mit dem erfindungsgemäßen Verfahren zur Ermittlung einer relativen Dielektrizitätszahl ε_{R} ist es somit für den Benutzer möglich schnell und in gewohnter Weise das Suchgerät im Hinblick auf die Bodenbeschaffenheit des zu untersuchenden Gebiets zu kalibrieren. Mit dem erfindungsgemäßen Detektionsverfahren, dem die ermittelte relative Dielektrizitätszahl zu Grunde liegt, werden dem Benutzer des Suchgeräts wesentliche für die Suche und die Detektion erforderliche Daten zur Verfügung gestellt. Für den Benutzer wird damit die Handhabung des Suchgeräts wesentlich vereinfacht, da ihm nach der Ermittlung der Dielektrizitätszahl aufgezeigt wird, wie er aufgrund der Dämpfung der elektromagnetischen Wellen im Erdreich die Grenzfrequenz für die Messung und auch die Verstärkung einstellen muss, um Objekte in einer von ihm gewünschten Tiefe detektieren zu können. Dabei wird ihm auch aufgezeigt, welche maximale Tiefe überhaupt aufgrund der ermittelten Dielektrizitätszahl detektiert werden kann.

## Patentansprüche

1. Verfahren zur Ermittlung einer relativen Dielektrizitätszahl ε_{R} eines nach metallischen und nichtmetallischen Gegenständen zu untersuchenden Erdreichs unter Verwendung eines Suchgeräts mit mindestens einer Suchspule und mit einem Bodenradar mit mindestens einer Sendeantenne und mindestens einer Empfangsantenne, **gekennzeichnet durch**
Durchführung von Messungen für einen repräsentativen Abschnitt des zu untersuchenden Erdreichs, in dem mittels des Suchgeräts über die mindestens eine Sendeantenne ein Sendesignal abgesandt und über die mindestens eine Empfangsantenne ein Empfangssignal empfangen und die vergangene Zeit gemessen wird, wenn das Suchgerät mit seiner für die Suche aktiven Seite
a) vom Erdreich abgewandt ist,
b) auf dem Erdreich aufliegt;
Bestimmung einer mittleren Signalgeschwindigkeit aus der Signallaufzeit über die Luft und über den direkten Signallaufweg in dem Suchgerät zwischen der Sendeantenne und der Empfangsantenne bei der Stellung a);
Bestimmung einer mittleren Signalgeschwindigkeit aus der Signallaufzeit zwischen der Sendeantenne und der Empfangsantenne mindestens über das Erdreich und über den direkten Signallaufweg in dem Suchgerät bei der Stellung b); und
Ermittlung der relativen Dielektrizitätszahl ε_{R} aus dem Verhältnis der beiden mittleren Signalgeschwindigkeiten gemäß den Messungen a) und b).

2. Verfahren nach Anspruch 1, **dadurch gekennzeichnet, dass** mindestens die aus der Atmosphäre auf den Bodenradar auftreffenden sowie die von dem Bodenradar in einer dem Erdreich entgegengesetzten Richtung ausgesandten elektromagnetischen Wellen mittels Absorberelementen abgeschirmt werden und die mittlere Signalgeschwindigkeit aus der Signallaufzeit zwischen der Sendeantenne und der Empfangsantenne über das Erdreich und dem direkten Signallaufweg in dem Suchgerät bei der Stellung b) bestimmt wird.

3. Detektionsverfahren zum Auffinden von metallischen und nichtmetallischen Gegenständen im Erdreich unter Verwendung eines Minensuchgeräts (1) mit einem Metalldetektor und einem Bodenradar, wobei der Metalldetektor mindestens eine Suchspule (5) mit einer Spulenebene, die beim Suchen parallel zum Boden zu bewegen ist, aufweist und der Bodenradar eine Antennenanordnung (6) mit mindestens einer Sendeantenne und einer mindestens Empfangsantenne versehen ist, **dadurch gekennzeichnet, dass**
zuerst für einen repräsentativen Abschnitt des zu untersuchenden Erdreichs Messungen zur Ermittlung einer relativen Dielektrizitätszahl ε_{R} gemäß Anspruch 1 oder 2 durchgeführt werden;
die ermittelte relative Dielektrizitätszahl einem definierten Messfrequenzbereich unter Berücksichtigung der frequenzabhängigen Dämpfung zugeordnet und die maximale frequenzabhängige und bodenabhängige Messtiefe ermittelt und mittels einer entsprechenden Anzeigeeinrichtung angezeigt werden; und
bodennah oberhalb des zu untersuchenden Erdreiches entlang eines zu untersuchenden Weges Messungen zum Auffinden von im Erdreich befindlichen Minen durchgeführt werden, wobei durch gleichzeitiges Aussenden von Signalen von der Suchspule und der mindestens einen Sendeantenne und Empfangen der von der Suchspule ausgesandten Impulse und der von der mindestens einen Sendeantenne ausgesandten und mittels der mindestens einen Empfangsantenne empfangenen Signale ein Bodenprofil erstellt wird, aus dem die Größe und die räumliche Lage eines im Boden befindlichen Gegenstandes ermittelt wird.

4. Detektionsverfahren nach Anspruch 3, **dadurch gekennzeichnet, dass** die ungefähre Tiefe eines detektierten Gegenstandes ermittelt und angezeigt wird.

5. Detektionsverfahren nach Anspruch 3 oder 4, **dadurch gekennzeichnet, dass** die ungefähre Größe eines detektierten Gegenstandes ermittelt und angezeigt wird.

6. Detektionsverfahren nach einem der vorangegangenen Ansprüche, **dadurch gekennzeichnet,** des für den Bodenradar eine Sendefrequenz zwischen 400 MHz und 3 GHz verwendet wird.
